(19) Europäisches Patentamt
European Patent Office
Office européen des brevets

(11) **EP 4 629 768 A1**

(12) **EUROPEAN PATENT APPLICATION**
published in accordance with Art. 153(4) EPC

(43) Date of publication:
08.10.2025 Bulletin 2025/41

(21) Application number: 23897660.9

(22) Date of filing: 24.11.2023

(51) International Patent Classification (IPC):
*H05K 9/00* (2006.01)      *B32B 7/022* (2019.01)
*B32B 7/025* (2019.01)     *B32B 15/08* (2006.01)
*H01F 1/26* (2006.01)      *H01F 1/37* (2006.01)
*H01Q 17/00* (2006.01)

(52) Cooperative Patent Classification (CPC):
B32B 7/022; B32B 7/025; B32B 15/08; H01F 1/26;
H01F 1/37; H01Q 17/00; H05K 9/00

(86) International application number:
PCT/JP2023/042096

(87) International publication number:
WO 2024/117012 (06.06.2024 Gazette 2024/23)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 28.11.2022 JP 2022189140

(71) Applicant: FUJIFILM Corporation
Tokyo 106-8620 (JP)

(72) Inventor: MIKAMI Tatsuo
Minamiashigara-shi, Kanagawa 250-0193 (JP)

(74) Representative: Klunker IP
Patentanwälte PartG mbB
Destouchesstraße 68
80796 München (DE)

(54) **ELECTROMAGNETIC WAVE SHIELDING MATERIAL, ELECTRONIC COMPONENT, AND ELECTRONIC DEVICE**

(57) There are provided an electromagnetic wave shielding material in which at least one of outermost layers of the electromagnetic wave shielding material is a metal layer, a breaking elongation of the electromagnetic wave shielding material is 40% or more, a product of a thickness and a tensile strength of the electromagnetic wave shielding material is 40 N/mm or less, and the electromagnetic wave shielding material includes one or more magnetic layers sandwiched between two metal layers, as well as an electronic component and an electronic apparatus which include the electromagnetic wave shielding material.

EP 4 629 768 A1

**Description**

Technical Field

The present invention relates to an electromagnetic wave shielding material, an electronic component, and an electronic apparatus.

Background Art

In recent years, an electromagnetic wave shielding material has attracted attention as a material for reducing the influence of an electromagnetic wave in various electronic components and various electronic apparatuses (see, for example, PLT1).

Citation List

Patent Literature

PLT1: JP2022-91579A

Summary of Invention

Technical Problem

An electromagnetic wave shielding material (hereinafter, also described as a "shielding material") is capable of exhibiting the function of shielding electromagnetic waves (shielding ability) by reflecting electromagnetic waves incident on the shielding material by the shielding material and/or by attenuating the electromagnetic waves in the inside the shielding material.

The following two performances can be mentioned as the performance desired for the electromagnetic wave shielding material.

The first is that a high shielding ability can be exhibited against electromagnetic waves. An electromagnetic wave shielding material that exhibits a high shielding ability against electromagnetic waves is desirable since it can contribute to significantly reducing the influence of electromagnetic waves on an electronic component and an electronic apparatus. Regarding this point, according to the study by the inventors of the present invention, further improvement in the shielding ability against a magnetic field wave in a low frequency region of about 100 kHz (kilohertz) to 1 MHz (megahertz) among electromagnetic waves is desired in electromagnetic wave shielding materials in the related art.

The second is that forming workability is excellent. The electromagnetic wave shielding material can be processed into various shapes in order to be incorporated into an electronic component or an electronic apparatus. Excellent forming workability can refer to that defects such as a shape defect and breakage are less likely to occur in a formed article obtained by forming processing. The electromagnetic wave shielding material having excellent forming workability is desirable since it can be formed into a desired shape while suppressing the occurrence of defects such as breakage.

In consideration of the above circumstances, an object of one aspect of the present invention is to provide an electromagnetic wave shielding material that is capable of exhibiting a high shielding ability against electromagnetic waves particularly against a magnetic field wave in a low frequency region of about 100 kHz to 1 MHz and is excellent in forming workability.

Solution to Problem

An aspect of the present invention is as follows.

[1] An electromagnetic wave shielding material,

in which at least one of outermost layers of the electromagnetic wave shielding material is a metal layer,
a breaking elongation of the electromagnetic wave shielding material is 40% or more,
a product of a thickness and a tensile strength of the electromagnetic wave shielding material is 40 N/mm or less, and
the electromagnetic wave shielding material includes one or more magnetic layers sandwiched between two metal layers.

[2] The electromagnetic wave shielding material according to [1],
in which both of the outermost layers of the electromagnetic wave shielding material are metal layers.
[3] The electromagnetic wave shielding material according to [1] or [2],
in which one or both of the outermost layers of the electromagnetic wave shielding material is a metal layer that sandwiches a magnetic layer together with another metal layer.
[4] The electromagnetic wave shielding material according to any one of [1] to [3],
in which the electromagnetic wave shielding material further includes one or more layers containing a resin between the magnetic layer sandwiched between the two metal layers and one or both of the two metal layers.
[5] The electromagnetic wave shielding material according to [4],
in which the resin is a polyester resin.
[6] The electromagnetic wave shielding material according to any one of [1] to [5],
in which the magnetic layer contains magnetic particles.
[7] The electromagnetic wave shielding material according to [6],
in which the magnetic layer further contains a resin.
[8] The electromagnetic wave shielding material according to any one of [1] to [7],
in which a thickness of the magnetic layer is 5 $\mu$m or more and 100 $\mu$m or less.
[9] The electromagnetic wave shielding material according to any one of [1] to [8],
in which one or both of the two metal layers sandwiching the magnetic layer is a layer that contains, as a main component, a metal selected from the group consisting of Al, Mg, and Cu.
[10] The electromagnetic wave shielding material according to any one of [1] to [9],
in which the breaking elongation of the electromagnetic wave shielding material is 40% or more and 100% or less.
[11] The electromagnetic wave shielding material according to any one of [1] to [10],
in which the product of the thickness and the tensile strength of the electromagnetic wave shielding material is 5 N/mm or more and 40 N/mm or less.
[12] The electromagnetic wave shielding material according to [1],

in which one or both of the outermost layers of the electromagnetic wave shielding material is a metal layer that sandwiches a magnetic layer together with another metal layer,
the electromagnetic wave shielding material further includes one or more layers containing a polyester resin between the magnetic layer sandwiched between the two metal layers and one or both of the two metal layers,
the magnetic layer contains magnetic particles and a resin,
a thickness of the magnetic layer is 5 $\mu$m or more and 100 $\mu$m or less,
one or both of the two metal layers sandwiching the magnetic layer is a layer that contains, as a main component, a metal selected from the group consisting of Al, Mg, and Cu,
the breaking elongation of the electromagnetic wave shielding material is 40% or more and 100% or less, and
the product of the thickness and the tensile strength of the electromagnetic wave shielding material is 5 N/mm or more and 40 N/mm or less.

[13] An electronic component comprising:
the electromagnetic wave shielding material according to any one of [1] to [12].
[14] An electronic apparatus comprising:
the electromagnetic wave shielding material according to any one of [1] to [12].

Effects of Invention

According to one aspect of the present invention, it is possible to provide an electromagnetic wave shielding material that is capable of exhibiting a high shielding ability against electromagnetic waves particularly against a magnetic field wave in a low frequency region of about 100 kHz to 1 MHz and is excellent in forming workability. In addition, according to one aspect of the present invention, it is possible to provide an electronic component and an electronic apparatus, which include the electromagnetic wave shielding material.

Description of embodiments

[Electromagnetic wave shielding material]

One aspect of the present invention relates to an electromagnetic wave shielding material. At least one of outermost layers of the electromagnetic wave shielding material is a metal layer, a breaking elongation of the electromagnetic wave shielding material is 40% or more, a product of a thickness and a tensile strength of the electromagnetic wave shielding material is 40 N/mm or less, and the electromagnetic wave shielding material includes one or more magnetic layers sandwiched between two metal layers.

In the present invention and the present specification, the "electromagnetic wave shielding material" shall refer to a material that is capable of exhibiting shielding ability against an electromagnetic wave of at least one frequency or at least a part of a range of a frequency band. The "electromagnetic wave" includes a magnetic field wave and an electric field wave. The "electromagnetic wave shielding material" can be a material that is capable of exhibiting shielding ability against one or both of a magnetic field wave of at least one frequency or at least a part of a range of a frequency band and an electric field wave of at least one frequency or at least a part of a range of a frequency band.

In the present invention and the present specification, "magnetic" means having a ferromagnetic property. Details of the magnetic layer will be described later.

In the present invention and the present specification, the thickness of the electromagnetic wave shielding material is determined as an arithmetic average of thicknesses at five randomly selected points of the electromagnetic wave shielding material. The thickness can be measured by known measuring means (for example, a micrometer). The thickness of each layer included in the electromagnetic wave shielding material shall be determined by imaging a cross section exposed by a known method with a scanning electron microscope (SEM) and determining an arithmetic average of thicknesses of five randomly selected points in the obtained SEM image.

In the present invention and the present specification, the breaking elongation and the tensile strength of the electromagnetic wave shielding material are determined by the following methods.

A measurement sheet having a length of 50 mm and a width of 10 mm is cut out from an electromagnetic wave shielding material to be measured. This measurement sheet is attached to a tensile tester, and a tensile test is carried out under the following measurement conditions. As a tensile tester, for example, a universal material testing instrument TENSILON (RTF-1310) manufactured by A&D Company, Limited can be used. In order to adapt the measurement sheet to the measurement environment, the measurement sheet is placed in the measurement environment for 15 minutes or more and then attached to the tensile tester to carry out the tensile test. The breaking elongation is determined as "breaking elongation [unit: %] = $100 \times$ L/distance between chucks", where L is the longest elongation of the test sheet elongated in the tensile test (that is, an elongation displacement in a length direction at a time point at which at least one layer is broken in the measurement sheet). The fact that at least one layer is broken can be determined by a decrease in stress in a stress-strain curve, visual observation, or the like. "Tensile strength [unit: N/mm$^2$]" is determined as the maximum value of the stress obtained during the tensile test.

(Measurement conditions)

Distance between chucks: 25 mm
Measurement environment: temperature of 23°C, relative humidity of 50%
Load cell: 500 newtons (N)
Tensile rate: 1 mm/min
Tensile direction: length direction

The inventors of the present invention speculate the electromagnetic wave shielding material as follows.

The fact that the breaking elongation is 40% or more and the product of the thickness and the tensile strength is 40 N/mm or less can contribute to the electromagnetic wave shielding material exhibiting excellent forming workability. Specifically, the fact that the breaking elongation is 40% or more can contribute to suppressing the occurrence of breakage in a formed article obtained by the forming processing. The fact that the product of the thickness and the tensile strength is 40 N/mm or less can contribute to obtaining a formed article having a desired shape by the forming processing, that is, suppressing the shape defect of the formed article.

The fact that the electromagnetic wave shielding material has a multilayer structure in which the magnetic layer is sandwiched between two metal layers and the fact that at least one of the outermost layers of the electromagnetic wave shielding material is a metal layer can contribute to the fact that the electromagnetic wave shielding material is capable of exhibiting a high shielding ability against a magnetic field wave in a low frequency region of about 100 kHz to 1 MHz. In addition, the fact that at least one of the outermost layers of the electromagnetic wave shielding material is a metal layer can contribute to suppressing edge peeling in a formed article obtained by forming processing.

However, the present invention is not limited to the speculation described in the present specification.

Hereinafter, the electromagnetic wave shielding material will be described in more detail.

<Breaking elongation>

From the viewpoint of improving forming workability, the breaking elongation of the electromagnetic wave shielding material is 40% or more, preferably 43% or more, and more preferably 46% or more. The breaking elongation of the electromagnetic wave shielding material can be, for example, 100% or less, 95% or less, or 90% or less. Meanwhile, from the viewpoint of further suppressing the occurrence of breakage in the formed article obtained by the forming processing, it is preferable that the value of the breaking elongation is larger, and thus the breaking elongation of the electromagnetic wave shielding material can also exceed the value exemplified here. A method of controlling the breaking elongation of the electromagnetic wave shielding material will be described later.

<Product of thickness and tensile strength>

From the viewpoint of improving the forming workability, the product of the thickness [unit: mm] and the tensile strength [unit: N/mm$^2$] of the electromagnetic wave shielding material is 40 N/mm or less, and can also be 35 N/mm or less or 30 N/mm or less. The fact that the product of the thickness and the tensile strength is 40 N/mm or less can contribute to obtaining a formed article having a desired shape by the forming processing, that is, suppressing the shape defect of the formed article. The product of the thickness and the tensile strength of the electromagnetic wave shielding material can be, for example, more than 0 N/mm, 1 N/mm or more, 5 N/mm or more, or 10 N/mm or more. From the viewpoint of further suppressing the shape defect of the formed article, the smaller the value of the product of the thickness and the tensile strength, the more preferable.

The thickness of the electromagnetic wave shielding material can be, for example, 0.050 mm or more or 0.100 mm or more, and can be, for example, 0.700 mm or less or 0.600 mm or less. The tensile strength of the electromagnetic wave shielding material can be, for example, 60 N/mm$^2$ or more or 70 N/mm$^2$ or more, and can be, for example, 100 N/mm$^2$ or less or 90 N/mm$^2$ or less. Meanwhile, the electromagnetic wave shielding material only needs to have a product of the thickness and the tensile strength of 40 N/mm or less, and the thickness and the tensile strength are not particularly limited. A method of controlling the tensile strength of the electromagnetic wave shielding material will be described later.

Hereinafter, the electromagnetic wave shielding material will be described in more detail.

<Magnetic layer>

(Magnetic material)

The magnetic layer is a layer containing a magnetic material. Examples of the magnetic material include magnetic particles. As the magnetic particle, one kind selected from the group consisting of magnetic particles generally called soft magnetic particles, such as metal particles and ferrite particles, can be used, or two or more kinds therefrom can be used in combination at any ratio. Since the metal particles generally have a saturation magnetic flux density of about 2 to 3 times as compared with ferrite particles, the metal particles can maintain specific magnetic permeability and exhibit shielding ability even under a strong magnetic field without magnetic saturation. Therefore, the magnetic particles to be contained in the magnetic layer are preferably metal particles. In the present invention and the present specification, a layer containing metal particles as the magnetic material shall correspond to the "magnetic layer".

Metal particle

Examples of the metal particles as the magnetic material include particles of Sendust (an Fe-Si-Al alloy), a permalloy (an Fe-Ni alloy), a molybdenum permalloy (an Fe-Ni-Mo alloy), a Fe-Si alloy, a Fe-Cr alloy, an Fe-containing alloy generally called the iron-based amorphous alloy, a Co-containing alloys generally called the cobalt-based amorphous alloy, an alloy generally called the nanocrystal alloy, iron, Permendur (an Fe-Co alloy). Among them, Sendust is preferable since it exhibits a high saturation magnetic flux density and a high specific magnetic permeability. The metal particle may contain, in addition to the constitutional element of the metal (including the alloy), elements contained in an additive that can be optionally added and/or elements contained in impurities that can be unintentionally mixed in a manufacturing process of the metal particle at any content rate. In the metal particle, the content of the constitutional element of the metal (including the alloy) is preferably 90.0% by mass or more and more preferably 95.0% by mass or more, and it may be 100% by mass or may be less than 100% by mass, 99.9% by mass or less, or 99.0% by mass or less.

In one form, a magnetic layer that exhibits a high magnetic permeability (specifically, a real part of a complex specific magnetic permeability) is preferable. In a case where a complex specific magnetic permeability is measured by a magnetic permeability measuring apparatus, a real part $\mu'$ and an imaginary part $\mu'$ are generally displayed. In the present invention and the present specification, a real part of a complex specific magnetic permeability shall refer to such a real part $\mu'$. Hereinafter, a real part of a complex specific magnetic permeability at a frequency of 100 kHz is also simply referred to as "magnetic permeability". The magnetic permeability can be measured by a commercially available magnetic permeability measuring apparatus or a magnetic permeability measuring apparatus having a known configuration. From the viewpoint that the electromagnetic wave shielding material can exhibit still more excellent shielding ability, it is preferable that the magnetic layer sandwiched between the two metal layers is a magnetic layer having a magnetic permeability (the real part of the complex specific magnetic permeability at a frequency of 100 kHz) of 30 or more. The magnetic permeability thereof is more preferably 40 or more, still more preferably 50 or more, still more preferably 60 or more, still more preferably 70 or more, even more preferably 80 or more, even still more preferably 90 or more, and even further still more preferably 100 or more. In addition, the magnetic permeability can be, for example, 200 or less, 190 or less, 180 or less, 170 or less, or 160 or less, and it can exceed the values exemplified here. From the viewpoint of further improving the shielding ability of the electromagnetic wave shielding material, the higher the magnetic permeability, the more preferable.

From the viewpoint of forming a magnetic layer that exhibits a high magnetic permeability, the magnetic particle is preferably a flat-shaped particle. In a case of arranging the long side direction of the flat-shaped particles to be closer to a state parallel to the in-plane direction of the magnetic layer, the magnetic layer can exhibit a higher magnetic permeability since the diamagnetic field can be reduced by aligning the long side direction of the particle with the vibration direction of the electromagnetic wave incident orthogonal to the electromagnetic wave shielding material. In the present invention and the present specification, the "flat-shaped particle" refers to a particle having an aspect ratio of 0.200 or less. The aspect ratio of the flat-shaped particles is preferably 0.150 or less, and more preferably 0.100 or less. The aspect ratio of the flat-shaped particles can be, for example, 0.010 or more, 0.020 or more, or 0.030 or more. It is possible to make the shape of the particle flat-shaped, for example, by carrying out the flattening process according to a known method. For the flattening process, for example, the description of JP2018-131640A can be referenced, and for example, the description of paragraphs 0016 and 0017 and the description of Examples of the same publication can be referenced. Examples of the magnetic layer that exhibits a high magnetic permeability include a magnetic layer containing flat-shaped particles of Sendust.

As described above, from the viewpoint of forming a layer that exhibits a high magnetic permeability as the magnetic layer, it is preferable to arrange the long side direction of the flat-shaped particles to be closer to a state parallel to the in-plane direction of the magnetic layer. From this point, the alignment degree which is a sum of an absolute value of the average value of alignment angles of the flat-shaped particles with respect to the surface of the magnetic layer and a variance of the alignment angles is preferably 30° or lower, more preferably 25° or lower, still more preferably 20° or lower, and even still more preferably 15° or lower. The alignment degree can be, for example, 3° or higher, 5° or higher, or 10° or higher, and it can be lower than the values exemplified here. A method of controlling the alignment degree will be described later.

In the present invention and the present specification, the aspect ratio of the magnetic particle and the alignment degree are determined according to the following methods.

A cross section of a magnetic layer is exposed according to a known method. A cross-sectional image is acquired as an SEM image regarding a randomly selected region of the cross-section. The imaging conditions are set to be an acceleration voltage of 2 kV and a magnification of 1,000 times, and an SEM image is obtained as the backscattered electron image.

Reading is carried out in grayscale with the cv2.imread () function of Image processing library OpenCV 4 (manufactured by Intel Corporation) by setting the second argument to 0, and a binarized image is obtained with the cv2.threshold () function, using an intermediate brightness between the high-brightness portion and the low-brightness portion as a boundary. A white portion (high-brightness portion) in the binarized image is defined as a magnetic particle.

Regarding the obtained binarized image, a rotational circumscribed rectangle corresponding to a portion of each magnetic particle is determined according to the cv2.minAreaRect () function, and the long side length, the short side length, and the rotation angle are determined as the return values of the cv2.minAreaRect () function. In a case of determining the total number of magnetic particles included in the binarized image, it shall be assumed that particles in which only a part of the particle is included in the binarized image are also included. Regarding the particles in which only a part of the particle is included in the binarized image, the long side length, the short side length, and the rotation angle of the portion included in the binarized image are determined. The ratio of the short side length to the long side length (short side length/long side length) determined in this way shall be denoted as the aspect ratio of each magnetic particle. In the present invention and the present specification, in a case where the number of magnetic particles which have an aspect ratio of 0.200 or less and is defined as flat-shaped particles is 10% or more on a number basis with respect to the total number of magnetic particles included in the binarized image, it shall be determined that the magnetic layer is a "magnetic layer including flat-shaped particles as the magnetic particles". In addition, from the rotation angle determined as above, an "alignment angle" is determined as a rotation angle with respect to a horizontal plane (the surface of the magnetic layer).

Particles having an aspect ratio of 0.200 or less, which are determined in the binarized image, are defined as flat-shaped particles. Regarding the alignment angles of all the flat-shaped particles included in the binarized image, the sum of the absolute value of the average value (arithmetic average) and the variance is determined. The sum determined in this way is referred to as the "alignment degree". It is noted that the coordinates of the circumscribed rectangle are calculated using the cv2.boxPoints () function, and an image in which the rotational circumscribed rectangle is superposed on the original image is created according to the cv2.drawContours () function, where a rotational circumscribed rectangle that is erroneously detected clearly is excluded from the calculation of the aspect ratio and the alignment degree. In addition, an average value (arithmetic average) of the aspect ratios of the particles defined as the flat-shaped particles shall be denoted as the aspect ratio of the flat-shaped particles to be contained in a magnetic layer to be measured. Such an aspect ratio can be 0.200 or less, and is preferably 0.150 or less and more preferably 0.100 or less. In addition, the aspect ratio can be, for example, 0.010 or more, 0.020 or more, or 0.030 or more.

The content of the magnetic particles in the magnetic layer can be, for example, 50% by mass or more, 60% by mass or more, 70% by mass or more, and 80% by mass or more with respect to the total mass of the magnetic layer, and it can be, for example, 100% by mass or less, 98% by mass or less, or 95% by mass or less.

In one form, as the magnetic layer, a sintered body (a ferrite plate) of ferrite particles or the like can be used. Considering that, for example, there is a case where the electromagnetic wave shielding material is cut out to a desired size and there is a case where the electromagnetic wave shielding material is bent into a desired shape, the magnetic layer is preferably a layer that contains a resin as compared with a ferrite plate which is a sintered body.

In one form, the magnetic layer sandwiched between the two metal layers can be a layer having insulating properties. In the present invention and the present specification, the "insulating properties" means that the electrical conductivity is smaller than 1 siemens (S)/m. The electrical conductivity of a certain layer is calculated according to the following expression from the surface electrical resistivity of the layer and the thickness of the layer. The electrical conductivity can be measured by a known method.

$$\text{Electrical conductivity [S/m]} = 1/(\text{surface electrical resistivity } [\Omega] \times \text{thickness [m]})$$

The inventors of the present invention presume that it is preferable that the magnetic layer is a layer having insulating properties in order for the electromagnetic wave shielding material to exhibit a higher shielding ability. From this point, the electrical conductivity of the magnetic layer is preferably smaller than 1 S/m, more preferably 0.5 S/m or less, still more preferably 0.1 S/m or less, and even still more preferably 0.05 S/m or less. The electrical conductivity of the magnetic layer can be, for example, $1.0 \times 10^{-12}$ S/m or more or $1.0 \times 10^{-10}$ S/m or more.

(Resin)

The magnetic layer can be a layer containing a resin, and it can be a layer containing a magnetic material (for example, magnetic particles) and a resin. In the present invention and the present specification, the "resin" means a polymer, and it shall include rubber and an elastomer as well. The polymer includes a homopolymer and a copolymer. The rubber includes natural rubber and synthetic rubber. The elastomer is a polymer that exhibits elastic deformation. In the present invention and the present specification, a layer containing both magnetic material and a resin shall correspond to the "magnetic layer". In the magnetic layer containing the magnetic material and the resin, the content of the resin can be, for example, 1 part by mass or more, 3 parts by mass or more, or 5 parts by mass or more per 100 parts by mass of the magnetic material, and it can be 20 parts by mass or less or 15 parts by mass or less.

The resin can act as a binder in the magnetic layer. Examples of the resin to be contained in the magnetic layer include known thermoplastic resins in the related art, a thermosetting resin, an ultraviolet curable resin, a radiation curable resin, a rubber-based material, and an elastomer. Specific examples thereof include a polyester resin, a polyethylene resin, a polyvinyl chloride resin, a polyvinyl butyral resin, a polyurethane resin, a polyester urethane resin, a cellulose resin, an acrylonitrile-butadiene-styrene (ABS) resin, a nitrile-butadiene rubber, a styrene-butadiene rubber, an epoxy resin, a phenol resin, an amide resin, a silicone resin, a styrene-based elastomer, an olefin-based elastomer, a vinyl chloride-based elastomer, a polyester-based elastomer, a polyamide-based elastomer, a polyurethane-based elastomer, and an acrylic elastomer.

In addition to the above-described components, the magnetic layer can also contain any amount of one or more known additives such as a curing agent, a dispersing agent, a stabilizer, and a coupling agent.

In a case where the electromagnetic wave shielding material includes only one magnetic layer, the thickness of this one magnetic layer can be, for example, 5 $\mu$m or more, and it is preferably 10 $\mu$m or more and more preferably 20 $\mu$m or more from the viewpoint of further improving the shielding ability of the electromagnetic wave shielding material. Meanwhile, the thickness of this one magnetic layer can be, for example, 100 $\mu$m or less or 90 $\mu$m or less, and it is preferably less than 90 $\mu$m, more preferably 80 $\mu$m or less, and still more preferably 70 $\mu$m or less, from the viewpoint of further improving forming workability.

In a case where the electromagnetic wave shielding material includes two or more magnetic layers, the thickness of each of the two or more magnetic layers (that is, the thickness per one layer) can be, for example, 5 $\mu$m or more, and it is preferably 10 $\mu$m or more and more preferably 20 $\mu$m or more from the viewpoint of further improving the shielding ability of the electromagnetic wave shielding material. Meanwhile, this one magnetic layer can be, for example, 100 $\mu$m or less or 90 $\mu$m or less, and it is preferably less than 90 $\mu$m and more preferably 80 $\mu$m or less, from the viewpoint of further improving forming workability. The respective thicknesses of the two or more magnetic layers can be the same thickness or thicknesses different from each other.

In a case where the electromagnetic wave shielding material includes only one magnetic layer, this one magnetic layer is a magnetic layer sandwiched between two metal layers.

In a case where the electromagnetic wave shielding material includes two or more magnetic layers, at least one magnetic layer can be a magnetic layer sandwiched between the two metal layers, and each of the two or more magnetic layers can also be a magnetic layer sandwiched between the two metal layers. Specific examples of the layer configuration of such an electromagnetic wave shielding material will be described later.

In any of the above cases, one or more other layers may be interposed between the magnetic layer and the metal layer. Such other layers will also be described later.

<Metal layer>

The electromagnetic wave shielding material has a multilayer structure in which the magnetic layer is sandwiched between two metal layers. The electromagnetic wave shielding material includes one or more such multilayer structures and can also include two or more such multilayer structures. That is, the electromagnetic wave shielding material includes at least two metal layers and can also include three or more layers of metal layer, or it includes at least one magnetic layer and can also include two or more magnetic layers. The two or more layers of metal layer included in the electromagnetic wave shielding material have the same composition and thickness in one form and differ in composition and/or thickness in another form. The same applies to a case where the electromagnetic wave shielding material includes two or more magnetic layers, and the same applies to a case where two or more other layers such as a resin layer described later are included in the electromagnetic wave shielding material.

**In** the present invention and the present specification, the "metal layer" shall refer to a layer containing a metal. The metal layer can be a layer containing one or more kinds of metals as a pure metal consisting of a single metal element, as an alloy of two or more kinds of metal elements, or as an alloy of one or more kinds of metal elements and one or more kinds of non-metal elements.

The metal layer included in the electromagnetic wave shielding material can be a layer that contains one or more kinds of metals selected from the group consisting of various pure metals and various alloys. The metal layer can exhibit an attenuation effect in the shielding material. This point is preferable from the viewpoint of improving the shielding ability of the electromagnetic wave shielding material. Since the attenuation effect increases as the propagation constant increases and the propagation constant increases as the electrical conductivity is higher, it is preferable that the metal layer contains a metal element having a high electrical conductivity. From this point, it is preferable that the metal layer contains, as a main component, a pure metal of Ag, Cu, Au, or Al, or an alloy containing any one of these. The pure metal is a metal consisting of a single metal element and may contain a trace amount of impurities. In general, a metal having a purity of 99.0% or more consisting of a single metal element is called a pure metal. The purity is on a mass basis. The alloy is generally prepared by adding one or more kinds of metal elements or non-metal elements to a pure metal to adjust the composition, for example, in order to prevent corrosion or improve the hardness. The main component in the alloy is a component having the highest ratio on a mass basis, and it can be, for example, a component that occupies 80.0% by mass or more (for example, 99.8% by mass or less) in the alloy. From the viewpoint of economic efficiency, the alloy is preferably an alloy of a pure metal of Cu or Al or an alloy containing Cu or Al as a main component, and from the viewpoint of high electrical conductivity, it is more preferably an alloy of a pure metal of Cu or an alloy containing Cu as a main component.

In one form, the purity of the metal in the metal layer, that is, the content of the metal in the metal layer can be 99.0% by mass or more, 99.5% by mass or more, or 99.8% by mass or more with respect to the total mass of the metal layer. Unless otherwise specified, the content of metal in the metal layer shall refer to the content on a mass basis. For example, as the metal layer, a pure metal or an alloy processed into a sheet shape can be used. For example, as the metal layer, a commercially available metal foil or a metal foil produced by a known method can be used. Regarding a pure metal of Cu, sheets (so-called copper foils) having various thicknesses are commercially available. For example, such a copper foil can be used as the metal layer. The copper foil includes, according to manufacturing methods thereof, an electrolytic copper foil obtained by precipitating a copper foil on a cathode by electroplating and a rolled copper foil obtained by applying heat and pressure to an ingot and stretching the ingot thinly. Any copper foil can be used as the metal layer of the electromagnetic wave shielding material. In addition, for example, regarding Al, sheets (so-called aluminum foils) having various thicknesses are commercially available. For example, such an aluminum foil can be used as the metal layer.

From the viewpoint of reducing the weight of the electromagnetic wave shielding material, one or both (preferably both) of the two metal layers sandwiching the magnetic layer is preferably a metal layer containing the metal selected from the group consisting of Al and Mg, and more preferably a layer containing, as a main component, the metal selected from the group consisting of Al and Mg. The main component of the metal layer is a component having the highest ratio on a mass basis. In a layer containing, as a main component, a metal selected from the group consisting of Al and Mg, Al or Mg is a component having the highest ratio on a mass basis in this layer. Such a layer may contain only Al or Mg among Al and Mg, or may contain Al and Mg. A value (specific gravity/electrical conductivity) obtained by dividing the specific gravity by the electrical conductivity is small both in Al and Mg. As a metal in which this value is smaller is used, the weight of the electromagnetic wave shielding material that exhibits a high shielding ability can be further reduced. As a value calculated from the literature value, for example, a value (specific gravity/electrical conductivity) obtained by dividing the specific gravity by the electrical conductivity of each of Cu, Al, and Mg is as follows. Cu: $1.5 \times 10^{-7}$ m/S, Al: $7.6 \times 10^{-8}$ m/S, Mg: $7.6 \times 10^{-8}$ m/S. From the above values, it can be said that Al and Mg are preferred metals from the viewpoint of reducing the weight of the electromagnetic wave shielding material. The metal layer containing a metal selected from the group consisting of Al and Mg can contain only one of Al and Mg in one form and can contain both in another form. From the viewpoint of reducing the weight of the electromagnetic wave shielding material, one or both (preferably both) of the two metal layers sandwiching the magnetic layer is preferably a metal layer in which the content of the metal selected from the group consisting of Al and Mg is 80.0% by mass or more, and still more preferably a metal layer in which the content of the metal selected from the group consisting of Al and Mg is 90.0% by mass or more. The metal layer containing at least Al among Al and Mg can be a metal layer in which the Al content is 80.0% by mass or more, and it can be a metal layer in which the Al content is 90.0% by mass or more. The metal layer containing at least Mg among Al and Mg can be a metal layer in which the Mg content is 80.0% by mass or more, and it can be a metal layer in which the Mg content is 90.0% by mass or more. The content of the metal selected from the group consisting of Al and Mg, the Al content, and the Mg content can be each, for example, 99.9% by mass or less. The content of the metal selected from the group consisting of Al and Mg, the Al content, and the Mg content are each the content with respect to the total mass of the metal layer.

From one or more viewpoints of the viewpoint of economic efficiency, the viewpoint of high electrical conductivity, and the viewpoint of reducing the weight of the electromagnetic wave shielding material, one or both (preferably both) of the two metal layers sandwiching the magnetic layer is preferably a metal layer containing the metal selected from the group consisting of Al, Mg, and Cu, and more preferably a layer containing, as a main component, the metal selected from the group consisting of Al, Mg, and Cu. In a layer containing, as a main component, a metal selected from the group consisting of Al, Mg, and Cu, Al, Mg, or Cu is a component having the highest ratio on a mass basis in this layer. Such a layer can contain only one kind of metal or two or three kinds of metals among Al, Mg, and Cu. From the one or more viewpoints, one or both (preferably both) of the two metal layers sandwiching the magnetic layer is preferably a metal layer in which the content of the metal selected from the group consisting of Al, Mg, and Cu is 80.0% by mass or more, and still more preferably a metal layer in which the content of the metal selected from the group consisting of Al, Mg, and Cu is 90.0% by mass or more. The metal layer containing at least Al among Al, Mg, and Cu can be a metal layer in which the Al content is 80.0% by mass or more, and it can be a metal layer in which the Al content is 90.0% by mass or more. The metal layer containing at least Mg among Al, Mg, and Cu can be a metal layer in which the Mg content is 80.0% by mass or more, and it can be a metal layer in which the Mg content is 90.0% by mass or more. The metal layer containing at least Cu among Al, Mg, and Cu can be a metal layer in which the Cu content is 80.0% by mass or more, and it can be a metal layer in which the Cu content is 90.0% by mass or more. The content of the metal selected from the group consisting of Al, Mg, and Cu, the Al content, the Mg content, and the Cu content can be each, for example, 99.9% by mass or less. The content of the metal selected from the group consisting of Al, Mg, and Cu, the Al content, the Mg content, and the Cu content are each the content with respect to the total mass of the metal layer.

From the viewpoint of further improving the processability of the metal layer and the shielding ability of the electromagnetic wave shielding material, the thickness of the metal layer in terms of the thickness per one layer is preferably 4 μm or more, more preferably 5 μm or more, and still more preferably 10 μm or more. On the other hand, from the viewpoint of the processability of the metal layer, the thickness of the metal layer in terms of the thickness per one layer is preferably 200 μm or less, more preferably 100 μm or less, and still more preferably 50 μm or less. In the electromagnetic wave shielding material, the thicknesses of the plurality of metal layers can be the same thickness or thicknesses different from each other.

<Layer containing resin>

The electromagnetic wave shielding material can include, in a multilayer structure in which the magnetic layer is sandwiched between the two metal layers, one or more layers containing a resin between one or both of the two metal layers and the magnetic layer. The layer containing a resin is a layer containing one or more kinds of resins. Hereinafter, a specific form of the layer containing a resin will be described.

(Pressure-sensitive adhesive layer)

A pressure-sensitive adhesive layer can be mentioned as one form of the layer containing a resin. In the present invention and the present specification, the "pressure-sensitive adhesive layer" refers to a layer having tackiness on a surface at normal temperature. Regarding the tackiness, the "normal temperature" shall be defined as 23°C. In a case where such a layer comes into contact with an adherend, the layer adheres to the adherend due to the adhesive force thereof. In general, the tackiness is the property of exhibiting an adhesive force in a short time after coming into contact with an adherend with a very light force, and in the present invention and the present specification, the above-described "having tackiness" refers to that the result is No. 1 to No. 32 in a tilted ball tack test (measurement environment: a temperature of 23°C and a relative humidity of 50%) specified in JIS Z 0237: 2009. In a case where another layer is laminated on the surface of the pressure-sensitive adhesive layer, the surface of the pressure-sensitive adhesive layer exposed, for example, by peeling off the other layer can be subjected to the above-described test. In a case where another layer is laminated on each of one surface and the other surface of the pressure-sensitive adhesive layer, the layer on the side of either surface may be peeled off.

As the pressure-sensitive adhesive layer, it is possible to use those obtained by applying a composition for forming a pressure-sensitive adhesive layer containing a pressure sensitive adhesive such as an acrylic pressure sensitive adhesive, a rubber-based pressure-sensitive adhesive, a silicone-based pressure-sensitive adhesive, or a urethane-based pressure-sensitive adhesive and processing it into a film shape.

The composition for forming a pressure-sensitive adhesive layer can be applied onto, for example, a support. The coating can be carried out using a known coating device such as a blade coater or a die coater. The coating can be carried out by a so-called roll-to-roll method or a batch method.

Examples of the support onto which the composition for forming a pressure-sensitive adhesive layer is applied include films of various resins such as polyester such as polyethylene terephthalate (PET) and polyethylene naphthalate (PEN), acryls such as polycarbonate (PC) and polymethyl methacrylate (PMMA), cyclic polyolefin, triacetyl cellulose (TAC), polyether sulfide (PES), polyether ketone, and polyimide. As the support, it is possible to use a support in which a surface (a surface to be coated) onto which the composition for forming a pressure-sensitive adhesive layer is applied is subjected to a peeling treatment according to a known method. One form of the peeling treatment includes forming a release layer. In addition, a commercially available peeling-treated resin film can also be used as the support. In a case of using a support in which the surface to be coated is subjected to the peeling treatment, it is possible to easily separate the pressure-sensitive adhesive layer and the support after the film formation.

By applying a composition for forming a pressure-sensitive adhesive layer, in which a pressure sensitive adhesive is dissolved and/or dispersed in a solvent, onto the surface to be coated and carrying out drying, a pressure-sensitive adhesive layer can be formed. Alternatively, a pressure sensitive adhesive tape including a pressure-sensitive adhesive layer can also be used. As the pressure sensitive adhesive tape, for example, it is possible to use a double-sided tape. The double-sided tape has pressure-sensitive adhesive layers on both sides of the support. In addition, as the pressure sensitive adhesive tape, it is possible to use a pressure sensitive adhesive tape having a pressure-sensitive adhesive layer on one surface of a support. Examples of the support include films of various resins such as polyester such as polyethylene terephthalate (PET) and polyethylene naphthalate (PEN), acryls such as polycarbonate (PC) and polymethyl methacrylate (PMMA), cyclic polyolefin, triacetyl cellulose (TAC), polyether sulfide (PES), polyether ketone, and polyimide, a non-woven fabric, and paper. As the pressure sensitive adhesive tape having a pressure-sensitive adhesive layer on one surface or both surfaces of a support, it is possible to use a commercially available product, or it is possible to use a pressure sensitive adhesive tape produced by a known method.

The thickness of the pressure-sensitive adhesive layer is not particularly limited, and the thickness per layer can be, for example, 1 $\mu$m or more and 30 $\mu$m or less.

(Adhesive layer)

An adhesive layer can also be mentioned as one form of the layer containing a resin. In the present invention and the present specification, the "adhesive layer" is a layer in which a liquid or gel-like adhesive is solidified after coming into contact with an adherend and undergoing a state change such as drying or curing, at that time, adhesiveness to the adherend is exhibited by an anchoring effect, a physical interaction, or formation of a chemical bond to the adherend. In one form, the adhesive layer can be a layer having no tackiness on the surface at normal temperature.

The adhesive contains a resin that is solidified after being dried or cured. Examples of such a resin include a vinyl acetate resin, an ethylene vinyl acetate resin, an epoxy resin, a cyanoacrylate resin, an acrylic resin, a polyurethane resin, a chloroprene rubber, and a styrene butadiene rubber. These resins may be in the form of a liquid or a gel in the resin itself. Alternatively, the solid resin may be dissolved in a solvent to be in a liquid or gel form. Examples of the solvent contained in the adhesive include water, ketone-based solvents such as acetone, methyl ethyl ketone, and cyclohexanone, acetic acid ester-based solvents such as ethyl acetate, butyl acetate, cellosolve acetate, propylene glycol monomethyl ether acetate, and carbitol acetate, carbitols such as cellosolve and butyl carbitol, aromatic hydrocarbon-based solvents such as toluene and xylene, and amide-based solvents such as dimethylformamide, dimethylacetamide, and N-methylpyrrolidone, alcohol-based solvents such as ethanol, methanol, and propanol, and halogen-based solvents such as dichloromethane, trichloroethylene, and dichlorofluoroethane.

The thickness of the adhesive layer is not particularly limited, and the thickness per layer can be, for example, 1 $\mu$m or more and 30 $\mu$m or less.

(Resin layer)

A resin layer can also be mentioned as one form of the layer containing a resin. In the present invention and the present specification, the "resin layer" is a resin film obtained by forming a thermoplastic resin such as a synthetic resin into a film shape, and the resin film has a film-like structure by itself and does not have tackiness at normal temperature.

Examples of the thermoplastic resin contained in the resin film include various resins such as a polyethylene (PE) resin, a polypropylene (PP) resin, a polyvinyl chloride (PVC) resin, a polystyrene (PS) resin, a vinyl acetate resin, a polyurethane resin, a polyvinyl alcohol resin, an ethylene vinyl acetate resin, styrene butadiene rubber, acrylonitrile butadiene rubber, silicone rubber, an olefin-based elastomer (PP), a styrene-based elastomer, an acrylonitrile-butadiene-styrene (ABS) resin, polyethylene terephthalate (PET), a polyester resin such as polyethylene naphthalate (PEN), a polycarbonate (PC) resin, an acrylic resin such as polymethyl methacrylate (PMMA), cyclic polyolefin, and triacetyl cellulose (TAC).

The resin layer can be bonded to a metal layer or a magnetic layer by interposing a pressure-sensitive adhesive layer or an adhesive layer. In addition, since the resin layer is a layer containing a thermoplastic resin, the resin layer has the property of being softened by heating and flows and follows minute protrusions and recessions on the surface of the adherend by being pressed against the adherend in a state of being heated, thereby capable of exhibiting an adhesive force due to the anchoring effect, and then it is cooled, whereby the adhered state can be maintained. Therefore, in one form, the resin layer and the other layer can be bonded to each other without interposing the pressure-sensitive adhesive layer or the adhesive layer.

From the viewpoint of controlling the breaking elongation of the electromagnetic wave shielding material to 40% or more, the thickness of the resin layer in terms of the thickness per one resin layer is preferably 10 $\mu$m or more and more preferably 12 $\mu$m or more. On the other hand, from the viewpoint of the controlling the product of the thickness and the tensile strength of the electromagnetic wave shielding material to 40 N/mm or less, the thickness of the resin layer in terms of the thickness per one resin layer is preferably 250 $\mu$m or less, more preferably 230 $\mu$m or less, still more preferably 210 $\mu$m or less, and even still more preferably 190 $\mu$m or less. The electromagnetic wave shielding material preferably includes, in a multilayer structure in which the magnetic layer is sandwiched between the two metal layers, one or more resin layers having a thickness in the above range between one or both of the two metal layers and the magnetic layer. For example, the multilayer structure can include one magnetic layer having a thickness in the above range between one metal layer of the two metal layers and the magnetic layer and/or between the other metal layer and the magnetic layer.

<Specific example of layer configuration>

The total number of layers of the magnetic layers included in the electromagnetic wave shielding material is such that, for example, one to four layers can be included. The electromagnetic wave shielding material includes one or more magnetic layers sandwiched between the two metal layers, and can also include two or more such magnetic layers. In addition, four or fewer layers of such magnetic layers can also be included.

In a case where the electromagnetic wave shielding material includes only one magnetic layer, this one magnetic layer is a magnetic layer sandwiched between the two metal layers.

In a case where the electromagnetic wave shielding material includes two or more magnetic layers, at least one layer of these two or more magnetic layers is a magnetic layer sandwiched between the two metal layers. Specifically, all or only a part of the magnetic layers included in the electromagnetic wave shielding material is a magnetic layer sandwiched between the two metal layers.

A multilayer structure in which the magnetic layer is sandwiched between the two metal layers of the electromagnetic wave shielding material can include one or more layers containing a resin between one or both of the two metal layers and the magnetic layer. The layer containing a resin, which is located between the metal layer and the magnetic layer, is preferably at least a resin layer. In one form, the electromagnetic wave shielding material can include one or more layers containing a polyester resin between one or both of the two metal layers and the magnetic layer, and the layer containing a polyester resin is preferably a resin layer.

The multilayer structure can include a pressure-sensitive adhesive layer and/or an adhesive layer between the resin layer and the metal layer. In one form, in the multilayer structure, the pressure-sensitive adhesive layer and/or the adhesive layer may be included between the resin layer and the magnetic layer. In another form, in the multilayer structure, the resin layer and the magnetic layer can be in direct contact with each other. That is, the resin layer and the magnetic layer can be adjacent to each other without interposing another layer. In addition, in the multilayer structure, at least one of the two metal layers and the magnetic layer can be in direct contact with each other. That is, at least one of the two metal layers and the magnetic layer can be adjacent to each other without interposing another layer.

The electromagnetic wave shielding material can include, for example, a total of 1 to 12 layers containing a resin. The total number of layers of resin layers (preferably the resin layers having the thickness described above) included in the electromagnetic wave shielding material can be, for example, one to four layers. The total number of layers of layers selected from the group consisting of the pressure-sensitive adhesive layer and the adhesive layer, which are included in the electromagnetic wave shielding material, can be, for example, one to four layers or one to eight layers.

One or both of the outermost layers is a metal layer in the electromagnetic wave shielding material. This point can contribute to the fact that the electromagnetic wave shielding material can exhibit a high shielding ability against a magnetic field wave in a low frequency region of about 100 kHz to 1 MHz. In addition, the fact that at least one of the outermost layers of the electromagnetic wave shielding material is a metal layer can contribute to suppressing edge peeling in a formed article obtained by forming processing. In one form, one or both of the outermost layers of the electromagnetic wave shielding material can be a metal layer that sandwiches a magnetic layer together with another metal layer.

Examples of the disposition of the "magnetic layer", the "metal layer", the "resin layer", and the "pressure-sensitive adhesive layer or adhesive layer" in the electromagnetic wave shielding material include the following examples. In the following, the symbol "/" means that the layer described on the left side of this symbol and the layer described on the right side of this symbol are in direct contact with each other without another layer being interposed therebetween. In the following Examples 1 to 3, the "pressure-sensitive adhesive layer" may include a support, and the "pressure-sensitive adhesive layer" may be a pressure sensitive adhesive tape having a pressure-sensitive adhesive layer on one or both surfaces of the support. For example, as in Example 3, metal layers that sandwich a certain magnetic layer can be metal layers that sandwich another magnetic layer. For example, in Example 3, the metal layer 2 is one of the two metal layers that sandwich the magnetic layer 1, and it is also one of the two metal layers that sandwich the magnetic layer 2. In addition, in Example 3, one of the outermost layers of the electromagnetic wave shielding material is the metal layer 1 that sandwiches the magnetic layer 1 together with the metal layer 2, and the other of the outermost layers of the electromagnetic wave shielding material is the metal layer 3 that sandwiches the magnetic layer 2 together with the metal layer 2.

Example 1: "Metal layer 1/pressure-sensitive adhesive layer 1 or adhesive layer 1/resin layer 1/magnetic layer 1/resin layer 2/pressure-sensitive adhesive layer 2 or adhesive layer 2/metal layer 2"

Example 2: "Metal layer 1/pressure-sensitive adhesive layer 1 or adhesive layer 1/resin layer 1/magnetic layer 1/metal layer 2/pressure-sensitive adhesive layer 2 or adhesive layer 2/resin layer 2"

Example 3: "Metal layer 1/pressure-sensitive adhesive layer 1 or adhesive layer 1/resin layer 1/magnetic layer 1/resin layer 2/pressure-sensitive adhesive layer 2 or adhesive layer 2/metal layer 2/pressure-sensitive adhesive layer 3 or adhesive layer 3/resin layer 3/magnetic layer 2/resin layer 4/pressure-sensitive adhesive layer 4 or adhesive layer 4/metal layer 3"

Example 4: "Metal layer 1/pressure-sensitive adhesive layer 1 or adhesive layer 1/resin layer 1/magnetic layer 1/metal layer 2/pressure-sensitive adhesive layer 2 or adhesive layer 2/resin layer 2/magnetic layer 2/resin layer 3/pressure-sensitive adhesive layer 3 or adhesive layer 3/metal layer 3"

Example 5: "Metal layer 1/pressure-sensitive adhesive layer 1 or adhesive layer 1/resin layer 1/magnetic layer 1/metal layer 2/pressure-sensitive adhesive layer 2 or adhesive layer 2/resin layer 2/magnetic layer 2/metal layer 3/pressure-sensitive adhesive layer 3 or adhesive layer 3/resin layer 3"

Example 6: "Metal layer 1/pressure-sensitive adhesive layer 1 or adhesive layer 1/resin layer 1/magnetic layer 1/metal layer 2/magnetic layer 2/resin layer 2/pressure-sensitive adhesive layer 2 or adhesive layer 2/metal layer 3"

Example 7: "Metal layer 1/pressure-sensitive adhesive layer 1 or adhesive layer 1/resin layer 1/magnetic layer 1/metal layer 2/magnetic layer 2/metal layer 3/pressure-sensitive adhesive layer 2 or adhesive layer 2/resin layer 2"

<Manufacturing method for electromagnetic wave shielding material>

(Film forming method for magnetic layer)

The magnetic layer can be produced, for example, by drying a coating layer that is provided by applying a composition for forming a magnetic layer. The composition for forming a magnetic layer can contain the components described above and can optionally contain one or more kinds of solvents. Examples of the solvent include various organic solvents, for example, ketone-based solvents such as acetone, methyl ethyl ketone, and cyclohexanone, acetic acid ester-based solvents such as ethyl acetate, butyl acetate, cellosolve acetate, propylene glycol monomethyl ether acetate, and carbitol acetate, carbitols such as cellosolve and butyl carbitol, aromatic hydrocarbon-based solvents such as toluene and xylene, and amide-based solvents such as dimethylformamide, dimethylacetamide, and N-methylpyrrolidone. One kind of solvent or two or more kinds of solvents selected in consideration of the solubility of the component that is used in the preparation of the composition for forming a magnetic layer can be mixed at any ratio and used. The solvent content of the composition for forming a magnetic layer is not particularly limited and may be determined in consideration of the coatability of the composition for forming a magnetic layer.

The composition for forming a magnetic layer can be prepared by sequentially mixing various components in any order or simultaneously mixing them. In addition, as necessary, a dispersion treatment can be carried out using a known dispersing machine such as a ball mill, a bead mill, a sand mill, or a roll mill, and/or a stirring treatment can be also carried out using a known stirrer such as a shaking type stirrer.

The composition for forming a magnetic layer can be applied onto, for example, a support. The coating can be carried out using a known coating device such as a blade coater or a die coater. The coating can be carried out by a so-called roll-to-roll method or a batch method.

Examples of the support onto which the composition for forming a magnetic layer is applied include films of various resins such as polyester such as polyethylene terephthalate (PET) and polyethylene naphthalate (PEN), acryls such as polycarbonate (PC) and polymethyl methacrylate (PMMA), cyclic polyolefin, triacetyl cellulose (TAC), polyether sulfide (PES), polyether ketone, and polyimide. For these resin films, reference can be made to paragraphs 0081 to 0086 of JP2015-187260A. As the support, it is possible to use a support in which a surface (a surface to be coated) onto which the composition for forming a magnetic layer is applied is subjected to a peeling treatment according to a known method. One form of the peeling treatment includes forming a release layer. For the release layer, reference can be made to paragraph 0084 of JP2015-187260A. In addition, a commercially available peeling-treated resin film can also be used as the support. In a case of using a support in which the surface to be coated is subjected to the peeling treatment, it is possible to easily separate the magnetic layer and the support after the film formation.

A coating layer formed by applying the composition for forming a magnetic layer can be subjected to a drying treatment according to a known method such as heating or warm air blowing. The drying treatment can be carried out, for example, under conditions in which the solvent contained in the composition for forming a magnetic layer can be volatilized. As an example, the drying treatment can be carried out for 1 minute to 2 hours in a heated atmosphere having an atmospheric temperature of 80°C to 150°C.

The alignment degree of the flat-shaped particle described above can be controlled by a solvent kind, solvent amount, liquid viscosity, coating thickness, and the like of the composition for forming a magnetic layer. For example, in a case where the boiling point of the solvent is low, convection occurs due to drying, and thus the value of the alignment degree tends to be large. In a case where the solvent amount is small, the value of the alignment degree tends to increase due to physical interference between adjacent flat-shaped particles. On the other hand, in a case where the liquid viscosity is low, the rotation of flat-shaped particles is more likely to occur, and thus the value of the alignment degree tends to be small. The value of the alignment degree tends to be small as the coating thickness decreases. In addition, carrying out a pressurization treatment described later can contribute to reducing the value of the alignment degree. In a case of adjusting the various manufacturing conditions described above, the alignment degree of the flat-shaped particles can be controlled within the range described above.

(Pressurization treatment of magnetic layer)

The magnetic layer can also be subjected to a pressurization treatment after film formation. In a case of subjecting the magnetic layer containing the magnetic particles to a pressurization treatment, it is possible to increase the density of the magnetic particles in the magnetic layer, and it is possible to obtain a higher magnetic permeability. In addition, in the magnetic layer containing the flat-shaped particles, it is possible to reduce the value of the alignment degree by the pressurization treatment, and it is possible to obtain a higher magnetic permeability.

The pressurization treatment can be carried out by applying pressure in the thickness direction of the magnetic layer using a flat plate pressing machine, a roll pressing machine, or the like. In the flat plate pressing machine, an object to be pressurized is disposed between two flat press plates that are disposed vertically, and the two press plates are put together by mechanical or hydraulic pressure to apply pressure to the object to be pressurized. In the roll pressing machine, an object to be pressurized is allowed to pass between the rotating pressurization rolls that are disposed vertically, and at that time, mechanical or hydraulic pressure is applied to the pressurization rolls, or the distance between the pressurization rolls is made to be smaller than the thickness of the object to be pressurized, whereby the pressure can be applied.

The pressure during the pressurization treatment can be set freely. For example, in a case of a flat plate pressing machine, it is, for example, 1 to 50 newtons (N)/mm². In a case of a roll pressing machine, it is, for example, 20 to 400 N/mm in terms of the linear pressure.

The pressurization time can be set freely. It takes, for example, 5 seconds to 30 minutes in a case where a flat plate pressing machine is used. In a case where a roll pressing machine is used, the pressurization time can be controlled by the transport speed of the object to be pressurized, where the transport speed is, for example, 10 cm/min to 200 m/min.

The materials of the press plate and the pressurization roll can be randomly selected from metal, ceramics, plastic, and rubber.

In the pressurization treatment, it is also possible to carry out a pressurization treatment by applying a temperature to both of upper and lower press plates of a plate-shape pressing machine or one press plate thereof, or one roll of upper and lower rolls of a roll pressing machine. The magnetic layer can be softened by heating, which makes it possible to obtain a high compression effect in a case where pressure is applied. The temperature at the time of heating can be set freely, and it is, for example, 50°C or higher and 200°C or lower. The temperature at the time of heating can be the internal temperature of the press plate or the roll. Such a temperature can be measured with a thermometer installed inside the press plate or the roll.

After the heating and pressurization treatment with the plate-shape pressing machine, the press plates can be spaced apart from each other, for example, in a state where the temperature of the press plates is high, whereby the magnetic layer can be taken out. Alternatively, the press plate can be cooled by a method such as water cooling or air cooling while maintaining the pressure, and then the press plates can be spaced apart to take out the magnetic layer.

In the roll pressing machine, the magnetic layer can be cooled immediately after pressing, by a method such as water cooling or air cooling.

It is also possible to repeat the pressurization treatment two or more times.

In a case where the magnetic layer is formed into a film on a release film, it is possible to carry out a pressurization treatment, for example, in a state where the magnetic layer is laminated on the release film. Alternatively, the magnetic layer can also be peeled off from the release film and can be subjected to a pressurization treatment as a single layer of the magnetic layer.

(Bonding of various layers)

A pressure-sensitive adhesive layer or an adhesive layer can be used for bonding various layers. The pressure-sensitive adhesive layer and the adhesive layer are as described above.

In addition, in the electromagnetic wave shielding material, two layers adjacent to each other can be also adhered to each other, for example, by applying pressure and heat to carry out crimping. A plate-shape pressing machine, a roll pressing machine, or the like can be used for the crimping. For example, in a case where the magnetic layer is disposed as a layer that is in direct contact with the adjacent layer, the magnetic layer is softened in a crimping step, and the contact with the surface of the adjacent layer is promoted, whereby the magnetic layer and the adjacent layer can be bonded to each other without interposing another layer. The pressure at the time of crimping can be set freely. It is, for example, 1 to 50 $N/mm^2$ in a case of a plate-shape pressing machine. In a case of a roll pressing machine, it is, for example, 20 to 400 N/mm in terms of the linear pressure. The pressurization time at the time of crimping can be set freely. It takes, for example, 5 seconds to 30 minutes in a case where a plate-shape pressing machine is used. In a case where a roll pressing machine is used, the pressurization time can be controlled by a transport speed of an object to be pressurized, and the transport speed is, for example, 10 cm/min to 200 m/min. The temperature at the time of crimping can be selected freely, and it is, for example, 20°C or higher and 200°C or lower. The temperature at the time of crimping can be, for example, the internal temperature of the press plate or the roll.

The electromagnetic wave shielding material can be incorporated into, in any shape, an electronic component or an electronic apparatus. The electromagnetic wave shielding material can have a sheet shape, where the size thereof is not particularly limited. In the present invention and the present specification, the "sheet" has the same meaning as the "film". In addition, the electromagnetic wave shielding material can be a three-dimensionally formed article obtained by three-dimensionally forming a sheet-shaped electromagnetic wave shielding material, or it can also be a sheet-shaped electromagnetic wave shielding material for three-dimensional forming. As a three-dimensional forming method, it is possible to use various forming methods such as mold press forming, vacuum forming, and air pressure forming. Regarding the forming method, the forming that is carried out without heating a forming target and/or a mold or carried out by heating a forming target and/or a mold without raising the temperature too much is generally called cold forming. The electromagnetic wave shielding material can exhibit excellent formability with respect to cold forming. Therefore, the electromagnetic wave shielding material is suitable for cold forming such as draw forming or bulge forming. The draw forming is a forming method in which a sheet-shaped forming target is pressed using a pair of molds of a female die and a male die, thereby being formed into bottomed containers having various shapes such as a cylinder, a square cylinder, and a conical shape. In contrast, a method of forming a formed article having a shape in which a curved surface protrudes from a flat surface, from a sheet-shaped forming target is bulge forming. The bulge forming can be carried out by pressing with only a male die without a female die. The draw forming is roughly classified into deep draw forming and shallow draw forming. A formed article having a shallow depth is formed by the shallow draw forming, and a formed article having a deep depth (for example, having a depth that is deeper than a diameter of a cylinder or a cone, or a length of one side of a pyramid) is formed by the deep draw forming. The electromagnetic wave shielding material can be an electromagnetic wave shielding material in which breakage is difficult to occur in a formed article formed by such a three-dimensional forming method. In addition, the electromagnetic wave shielding material can be an electromagnetic wave shielding material in which edge peeling is difficult to occur in a formed article formed by such a three-dimensional forming method. Known techniques can be applied to the three-dimensional forming method.

[Electronic component] One aspect of the present invention relates to an electronic component including the electromagnetic wave shielding material. Examples of the electronic component include an electronic component included in an electronic apparatus such as a mobile phone, a mobile information terminal, and a medical device, and various electronic components such as a semiconductor element, a capacitor, a coil, and a cable. The electromagnetic wave shielding material is three-dimensionally formed into any shape, for example, according to the shape of the electronic component, thereby capable of being disposed in the inside of the electronic component, or it is three-dimensionally formed into a shape of a cover material, thereby capable of being disposed as a cover material that covers the outside of the electronic component. Alternatively, it can be three-dimensionally formed into a tubular shape, thereby being disposed as a cover material that covers the outside of the cable.

[Electronic apparatus]

One aspect of the present invention relates to an electronic apparatus including the electromagnetic wave shielding material. Examples of the electronic apparatus include electronic apparatuses such as a mobile phone, a mobile information terminal, and a medical device, electronic apparatuses including various electronic components such as a semiconductor element, a capacitor, a coil, and a cable, and electronic apparatuses in which electronic components are mounted on a circuit board. Such an electronic apparatus can include the electromagnetic wave shielding material as a constitutional member of an electronic component included in the device. In addition, as a constitutional member of the electronic apparatus, the electromagnetic wave shielding material can be disposed in the inside of the electronic apparatus or can be disposed as a cover material that covers the outside of the electronic apparatus. Alternatively, it can be three-dimensionally formed into a tubular shape, thereby being disposed as a cover material that covers the outside of the cable.

Examples of the usage form of the electromagnetic wave shielding material include a usage form in which a semiconductor package on a printed board is coated with a shielding material. For example, "Electromagnetic wave shielding technology in a semiconductor package" (Toshiba Review Vol. 67, No. 2 (2012) P. 8) discloses a method of obtaining a high shielding effect by electrically connecting a side via of an end part of a package substrate and an inner surface of a shielding material in a case where a semiconductor package is coated with a shielding material, thereby carrying out ground wiring. In order to carry out such wiring, it is desirable that the outermost layer of the shielding material on the electronic component side is a metal layer. Since one or both of the outermost layers of the shielding material is a metal layer in the electromagnetic wave shielding material, the electromagnetic wave shielding material can be suitably used in a case of carrying out the wiring as described above.

Examples

Hereinafter, the present invention will be described in more detail with reference to Examples. However, the present invention is not limited to the embodiments shown in Examples.

[Example 1]

<Preparation of composition for forming magnetic layer (coating liquid)>

To a plastic bottle, the following substances were added and mixed with a shaking type stirrer for 1 hour to prepare a coating liquid;

100 g of Fe-Si-Al flat-shaped magnetic particles (MFS-SUH manufactured by MKT),
27.5 g of a polyurethane resin of a concentration of solid contents of 30% by mass (UR-6100, manufactured by TOYOBO Co., Ltd.),
0.5 g of a polyfunctional isocyanate (CORONATE L manufactured by Tosoh Corporation), and
233 g of cyclohexanone.

<Production of magnetic layer>

A coating liquid was applied onto a peeling surface of a peeling-treated polyethylene terephthalate (PET) film (PET75JOL manufactured by NIPPA Co., Ltd., hereinafter also described as a "release film") with a blade coater having a coating gap of 300 $\mu$m and dried for 30 minutes in a drying device having an internal atmospheric temperature of 80°C to obtain a film-shaped magnetic layer.

Upper and lower press plates of a plate-shape pressing machine (a large-scale hot press TA-200-1W manufactured by YAMAMOTO ENG. WORKS Co., LTD.) were heated to 140°C (the internal temperature of the press plate), and the magnetic layer on the release film was installed in the center of the press plate together with the release film and held for 10 minutes in a state where a pressure of 4.66 N/mm$^2$ was applied. The upper and lower press plates were cooled to 50°C (the internal temperature of the press plates) while maintaining the pressure, and then the magnetic layer was taken out together with the release film.

A part of the magnetic layer from which the release film was already peeled off was cut out and used as a sample piece for the following evaluation of the magnetic layer. A magnetic layer having a size of 15 cm × 15 cm was cut out from the magnetic layer from which the sample piece was already cut out, and used in the following production of an electromagnetic wave shielding material.

<Production of electromagnetic wave shielding material>

Alpet 50-50K manufactured by PANAC Co., Ltd. (a laminate in which an aluminum foil (metal layer having an Al content of 99.0% by mass or more) having a thickness of 50 μm and a polyester film (resin layer) having a thickness of 50 μm were bonded to each other by interposing an adhesive layer having a thickness of 3 μm interposed therebetween) was cut out to a size of 15 cm × 15 cm, and two laminates having a size of 15 cm × 15 cm were prepared.

The magnetic layer cut out as described above was superposed on one polyester film of the above two laminates, and the other laminate was superposed on the magnetic layer such that the polyester film was in contact with the magnetic layer. In this way, a laminate including a magnetic layer was obtained.

Upper and lower press plates of a plate-shape pressing machine (a large-scale hot press TA-200-1W manufactured by YAMAMOTO ENG. WORKS Co., LTD.) were heated to 140°C (the internal temperature of the press plate), and the laminate including the magnetic layer was installed in the center of the press plate and held for 10 minutes in a state where a pressure of 4.66 N/mm$^2$ was applied, whereby being subjected to the thermal compression bonding. The upper and lower press plates were cooled to 50°C (the internal temperature of the press plates) while maintaining the pressure, and then the laminate after the thermal compression bonding was taken out.

By the above-described method, an electromagnetic wave shielding material having a layer configuration shown in Table 2 was produced.

[Evaluation method]

<Measurement of magnetic permeability of magnetic layer>

A rectangular sample piece having a size of 28 mm × 10 mm was cut out from the magnetic layer, the magnetic permeability was measured using a magnetic permeability measuring apparatus (per01 manufactured by KEYCOM Corporation), and the magnetic permeability was determined as the real part ($\mu$') of the complex specific magnetic permeability at a frequency of 100 kHz. The determined magnetic permeability was 148.

<Measurement of electrical conductivity of magnetic layer>

A cylindrical main electrode having a diameter of 30 mm was connected to the negative electrode side of a digital super-insulation resistance meter (TR-811A manufactured by Takeda RIKEN Industries), a ring electrode having an inner diameter of 40 mm and an outer diameter of 50 mm was connected to the positive electrode side thereof, the main electrode was installed on a sample piece of the magnetic layer cut out to a size 60 mm × 60 mm, the ring electrode was installed at a position surrounding the main electrode, a voltage of 25 V was applied to both electrodes, and the surface electrical resistivity of the magnetic layer alone was measured. The electrical conductivity of the magnetic layer was calculated from the surface electrical resistivity and the following expression. The calculated electrical conductivity was 1.1 × 10$^{-2}$ S/m. As the thickness, the thickness of the magnetic layer, which had been determined according to the following method, was used.

$$\text{Electrical conductivity [S/m]} = 1/(\text{surface electrical resistivity } [\Omega] \times \text{thickness [m]})$$

<Acquisition of cross-sectional image of shielding material>

Cross-section processing was carried out to expose the cross-section of the shielding material of Example 1 according to the following method.

A shielding material cut out to a size of 3 mm × 3 mm was embedded in a resin, and a cross section of the shielding material was cut out with an ion milling device (IM4000PLUS manufactured by Hitachi High-Tech Corporation).

The cross-section of the shielding material, which had been exposed in this way, was observed with a scanning electron microscope (SU8220, manufactured by Hitachi High-Tech Corporation) under the conditions of an acceleration voltage of 2 kV and a magnification of 100 times to obtain a backscattered electron image. From the obtained image, the thicknesses of five points were measured for the magnetic layer, each metal layer, each resin layer, and each adhesive layer with the scale bar as a reference, respectively, and the arithmetic average of each was used as the thickness of the magnetic layer, the thickness of each metal layer (the thickness per one metal layer), the thickness of each resin layer (the thickness per one resin layer), and the thickness of each adhesive layer (the thickness per one adhesive layer). Each thickness was a value shown in Table 2.

<Acquisition of cross-sectional image of magnetic layer>

In a cross section of the shielding material of Example 1, which had been exposed by the cross-section processing in the same manner as described above, a portion of the magnetic layer was observed with a scanning electron microscope (SU8220, manufactured by Hitachi High-Tech Corporation) under the conditions of an acceleration voltage of 2 kV and a magnification of 1,000 times, thereby obtaining a backscattered electron image.

<Measurement of aspect ratio of magnetic particle and alignment degree of flat-shaped particle>

Using the backscattered electron image acquired as above, the aspect ratio of the magnetic particles was determined according to the method described above, and the flat-shaped particles were specified from the value of the aspect ratio. As a result of determining, as described above, whether or not the magnetic layer contained flat-shaped particles as the magnetic particles, it was determined that the magnetic layer contains flat-shaped particles. Further, as a result of determining the alignment degree of the magnetic particles specified as the flat-shaped particles, according to the method described above, the alignment degree was 13°. In addition, an average value (arithmetic average) of the aspect ratios of all the particles specified as the flat-shaped particles was determined as the aspect ratio of the flat-shaped particles contained in the magnetic layer. The determined aspect ratio was 0.071.

[Breaking elongation and product of thickness and tensile strength of shielding material]

A measurement sheet having a length of 50 mm and a width of 10 mm was cut out from the electromagnetic wave shielding material in Example 1. The thickness of the cut-out sheet was measured at five randomly selected points using a micrometer (E-ST-100) manufactured by Tokyo Seimitsu Co., Ltd., and the arithmetic average thereof was used as the thickness of the shielding material. A tensile test of the measurement sheet was carried out by the method described above by using, as a tensile tester, a universal material testing instrument TENSILON (RTF-1310) manufactured by A&D Company, Limited, thereby determining the breaking elongation and the tensile strength. Table 2 shows the thickness, the breaking elongation, the tensile strength, and the calculated value of the product of the thickness and the tensile strength of the shielding material determined as described above.

[Evaluation of shielding ability]

The shielding ability of the electromagnetic wave shielding material of Example 1 was measured according to a KEC method as described below. It is noted that KEC is an abbreviation for Kansai Electronic Industry Development Center.
A signal generator (SG-4222, manufactured by Iwatsu Electric Co., Ltd.) and an input-side connector of a KEC method magnetic field antenna (JSE-KEC, manufactured by Techno Science Japan Co., Ltd.) were connected using an N-type cable.
An output-side connector of a broadband amplifier 315 and an input-side connector of a spectrum analyzer (RSA-3015T, manufactured by RIGOL TECHNOLOGIES, INC.) were connected using an N-type cable.
A measurement specimen (electromagnetic wave shielding material) was installed between the facing antennas of the KEC method magnetic field antenna, the signal generator and the spectrum analyzer were set as shown in Table 1, and a peak button of the spectrum analyzer was pressed to measure the peak voltage of the signal. It is noted that in Table 1, the scale "10 dB/div" indicates 10 dB per division. The "div" is an abbreviation for "division". In addition, the peak voltage was measured in the same manner even in a state where there was no measurement specimen, and the shielding ability was calculated according to the following expression. "dB" is an abbreviation for decibel, and "dBm" is an abbreviation for decibel milliwatt.
Shielding ability [dB] = a peak voltage [dBm] in a state where a measurement specimen is not present - a peak voltage [dBm] in a state where a measurement specimen is installed
The shielding ability at a frequency of 100 kHz and the shielding ability at a frequency of 1 MHz were each the values shown in Table 2. The shielding ability at a frequency of 100 kHz is preferably 25 dB or more. The shielding ability at a frequency of 1 MHz is preferably 45 dB or more and more preferably 55 dB or more.

[Table 1]

| Device | Setting | |
|---|---|---|
| Signal generator (SG-4222, manufactured by Iwatsu Electric Co., Ltd.) | Waveform | Sin (sine wave) |
| | Frequency | 300 kHz |
| | Output impedance | 50 Ω |
| | Output | 7 dBm |
| Spectrum analyzer (RSA-3015T, manufactured by RIGOL TECHNOLOGIES, INC.) | start frequency | 295 kHz |
| | stop frequency | 305 kHz |
| | Reference level | -10 dBm |
| | Scale | 10 dB/div |
| | RBW (Resolution Band Width) | 10 Hz |
| | VBW (Video band Width) | 1 Hz |

[Evaluation of forming workability]

Using a square mold for draw forming having a side length of 50 mm, a depth of 20 mm, a corner R of 10 mm on the bottom surface, and a corner R of 6 mm on the side surface, the electromagnetic wave shielding material cut out to a size of 75 mm × 75 mm was formed to a depth of 15 mm (in Table 2, "forming depth") with a blank holding force of 0.2 N. The above-described "corner R" is a curvature radius. For the following Examples and Comparative Examples, the depth of the formed article obtained by forming under the same draw forming conditions as in Example 1 is shown in the column of the forming depth in Table 2.

In addition, the formed article obtained by the draw forming was visually observed, and the presence or absence of breakage on the surface of the formed article and the presence or absence of edge peeling of the formed article were evaluated. In the evaluation of the presence or absence of edge peeling, a case where interlayer peeling or in-layer cracking occurred in the electromagnetic wave shielding material was evaluated as "Present" by visually observing the edge surface of the formed article, and a case where neither interlayer peeling nor in-layer cracking was confirmed was evaluated as "Absent".

The above-described evaluation was also carried out for each of the electromagnetic wave shielding materials of Examples and Comparative Examples described below.

[Example 2]

<Formation of aluminum foil with resin layer>

An aluminum foil having a thickness of 50 μm (in accordance with the JIS H4160: 2006 standard, alloy number: 1N30, temper designation: (1)O, Al content: 99.3% by mass or more) and a PET film having a thickness of 50 μm (Lumirror 50-T60 manufactured by Toray Industries, Inc.) were bonded to each other through a double-sided tape having a thickness of 5 μm (NeoFix 5S2 manufactured by NEION Film Coatings Corp.) to form an aluminum foil with a resin layer (a laminate in which a metal layer and a resin layer were bonded to each other through a double-sided tape including a pressure-sensitive adhesive layer). This aluminum foil with a resin layer was cut out to a size of 15 cm × 15 cm, and two laminates having a size of 15 cm × 15 cm were prepared. The above-described double-sided tape (NeoFix 5S2 manufactured by NEION Film Coatings Corp.) is a double-sided tape having pressure-sensitive adhesive layers (thickness of each pressure-sensitive adhesive layer: 1.5 μm) on both sides of a PET film having a thickness of 2 μm.

<Production of electromagnetic wave shielding material>

An electromagnetic wave shielding material having a layer configuration shown in Table 2 was produced according to the method described for Example 1, except that the two laminates were used and superposed so that the PET film and the magnetic layer were in contact with each other.

[Example 3]

<Formation of pressure-sensitive adhesive layer>

(Preparation of composition for forming pressure-sensitive adhesive layer (coating liquid))

To a plastic bottle, the following substances were added and mixed with a shaking type stirrer for 1 hour to prepare a coating liquid;

100 g of a polyurethane resin of a concentration of solid contents of 30% by mass (UR-6100, manufactured by TOYOBO Co., Ltd.), and
900 g of methyl ethyl ketone.

(Formation of film of pressure-sensitive adhesive layer)

A coating liquid was applied onto an aluminum foil (in accordance with the JIS H4160: 2006 standard, alloy number: 1N30, temper designation: (1)O, Al content: 99.3% by mass or more) having a thickness of 50 μm with a blade coater having a coating gap of 300 μm and dried for 30 minutes in a drying device having an internal atmospheric temperature of 80°C to form a pressure-sensitive adhesive layer having a thickness of 3 μm in a film shape.

<Formation of aluminum foil with resin layer>

Upper and lower press plates of a plate-shape pressing machine (a large-scale hot press TA-200-1W manufactured by YAMAMOTO ENG. WORKS Co., LTD.) were heated to 140°C (the internal temperature of the press plate), an aluminum foil with a pressure-sensitive adhesive layer was installed in the center of the press plate with the pressure-sensitive adhesive layer facing the upper surface side, and a PET film (Lumirror 25-T60, manufactured by Toray Industries, Inc.) having a thickness of 25 μm was installed on the pressure-sensitive adhesive layer and held for 10 minutes in a state where a pressure of 4.66 N/mm$^2$ was applied. After the upper and lower press plates were cooled to 50°C (the internal temperature of the press plate) while maintaining the pressure, the aluminum foil with a resin layer (a laminate in which a metal layer and a resin layer were bonded to each other with a pressure-sensitive adhesive layer interposed therebetween) was taken out.
This aluminum foil with a resin layer produced in this way was cut out to a size of 15 cm × 15 cm, and two laminates having a size of 15 cm × 15 cm were prepared.

<Production of electromagnetic wave shielding material>

An electromagnetic wave shielding material having a layer configuration shown in Table 2 was produced according to the method described for Example 1, except that the two laminates were used and superposed so that the PET film and the magnetic layer were in contact with each other.

[Example 4]

An electromagnetic wave shielding material having a layer configuration shown in Table 2 was produced according to the method described for Example 3, except that the PET film was changed to a thickness of 12 μm (Lumirror 12-S10 manufactured by Toray Industries, Inc.).

[Example 5]

An electromagnetic wave shielding material having a layer configuration shown in Table 2 was produced according to the method described for Example 3, except that the PET film was changed to a thickness of 188 μm (Lumirror 188-T60 manufactured by Toray Industries, Inc.).

[Example 6]

An electromagnetic wave shielding material having a layer configuration shown in Table 2 was produced by the method described for Example 1, except that one of two laminates cut out to a size of 15 cm × 15 cm from Alpet 50-50K manufactured by PANAC Co., Ltd. was disposed such that the aluminum foil was in contact with the magnetic layer.
[Comparative Example 1] An electromagnetic wave shielding material having a layer configuration shown in Table 2 was produced by the method described for Example 1, except that each of two laminates cut out to a size of 15 cm × 15 cm from Alpet 50-50K manufactured by PANAC Co., Ltd. was disposed such that the aluminum foil was in contact with the magnetic layer.

[Comparative Example 2]

An electromagnetic wave shielding material having a layer configuration shown in Table 2 was produced according to the method described for Example 3, except that the PET film was changed to a thickness of 9 μm (T4100 manufactured TOYOBO Co., Ltd.).

[Comparative Example 3]

An electromagnetic wave shielding material having a layer configuration shown in Table 2 was produced according to the method described for Example 3, except that the PET film was changed to a thickness of 255 μm (Lumirror 255-T60 manufactured by Toray Industries, Inc.).

[Comparative Example 4]

Two aluminum foils having a size of 15 cm × 15 cm were cut out from an aluminum foil having a thickness of 50 μm (in accordance with the JIS H4160: 2006 standard, alloy number: 1N30, temper designation: (1)O, Al content: 99.3% by mass or more).
A magnetic layer having a size of 15 cm × 15 cm, which was obtained by the method described for Example 1, was superposed on one of the two aluminum foils, and the other aluminum foil was superposed on the magnetic layer to obtain a laminate.
Upper and lower press plates of a plate-shape pressing machine (a large-scale hot press TA-200-1W manufactured by YAMAMOTO ENG. WORKS Co., LTD.) were heated to 140°C (the internal temperature of the press plate), and the laminate was installed in the center of the press plate and held for 10 minutes in a state where a pressure of 4.66 N/mm$^2$ was applied, whereby being subjected to the thermal compression bonding. The upper and lower press plates were cooled to 50°C (the internal temperature of the press plates) while maintaining the pressure, and then the laminate after the thermal compression bonding was taken out.
In this way, an electromagnetic wave shielding material having a layer configuration shown in Table 2 was produced.

[Comparative Example 5]

Two laminates cut out to a size of 15 cm × 15 cm from Alpet 50-50K manufactured by PANAC Co., Ltd. were bonded to each other with a double-sided tape (NeoFix 5S2 manufactured by NEION Film Coatings Corp.) having a thickness of 5 μm, with the polyester film side facing inward.
In this way, an electromagnetic wave shielding material having a layer configuration shown in Table 2 was produced.

[Comparative Example 6]

Two aluminum foils having a size of 15 cm × 15 cm were cut out from an aluminum foil having a thickness of 50 μm (in accordance with the JIS H4160: 2006 standard, alloy number: 1N30, temper designation: (1)O, Al content: 99.3% by mass or more).
Each of the two aluminum foils was bonded to each of both surfaces of the magnetic layer having a size of 15 cm × 15 cm, which was obtained by the method described for Example 1, through a double-sided tape (NeoFix 5S2, manufactured by NEION Film Coatings Corp.) having a thickness of 5 μm.

[Table 2]

| | Layer configuration | Thickness of magnetic layer [μm] | Thickness of metal layer [μm] | Thickness of resin layer [μm] | Thickness of adhesive layer, pressure-sensitive adhesive layer, or double-sided tape [μm] | Presence or absence of magnetic layer sandwiched between two layers of metal layer | At least one of outermost layers is metal layer | Breaking elongation of shielding material [%] | Thickness of shielding material [μm] | Tensile strength of shielding material [N/mm²] | Product of thickness and tensile strength of shielding material [N/mm] | Shielding ability [dB] 100 kHz | Shielding ability [dB] 1 MHz | Forming depth [mm] | Presence or absence of breakage of formed article | Presence or absence of edge peeling of formed article |
|---|---|---|---|---|---|---|---|---|---|---|---|---|---|---|---|---|
| Example 1 | Metal layer/adhesive layer/resin layer/magnetic layer/resin layer/adhesive layer/metal layer | 35 | 50 | 50 | 3 | Present | Satisfying | 86% | 0.241 | 81 | 20 | 29 | 64 | 15 | Absent | Absent |
| Example 2 | Metal layer/double-sided tape/resin layer/magnetic layer/resin layer/double-sided tape/metal layer | 35 | 50 | 50 | 5 | Present | Satisfying | 85% | 0.245 | 78 | 19 | 29 | 65 | 15 | Absent | Absent |
| Example 3 | Metal layer/pressure-sensitive adhesive layer/resin layer/magnetic layer/resin layer/pressure-sensitive adhesive layer/metal layer | 35 | 50 | 25 | 3 | Present | Satisfying | 65% | 0.191 | 77 | 15 | 29 | 64 | 15 | Absent | Absent |
| Example 4 | Metal layer/pressure-sensitive adhesive layer/resin layer/magnetic layer/resin layer/pressure-sensitive adhesive layer/metal layer | 35 | 50 | 12 | 3 | Present | Satisfying | 47% | 0.165 | 73 | 12 | 30 | 63 | 15 | Absent | Absent |
| Example 5 | Metal layer/pressure-sensitive adhesive layer/resin layer/magnetic layer/resin layer/pressure-sensitive adhesive layer/metal layer | 35 | 50 | 188 | 3 | Present | Satisfying | 86% | 0.517 | 75 | 39 | 30 | 66 | 15 | Absent | Absent |
| Example 6 | Metal layer/adhesive layer/resin layer/magnetic layer/metal layer/adhesive layer/resin layer | 35 | 50 | 50 | 3 | Present | Satisfying | 84% | 0.241 | 78 | 19 | 29 | 49 | 15 | Absent | Absent |
| Comparative Example 1 | Resin layer/adhesive layer/metal layer/magnetic layer/metal layer/adhesive layer/resin layer | 35 | 50 | 50 | 3 | Present | Not satisfying | 83% | 0.241 | 83 | 20 | 28 | 40 | 15 | Absent | Present |
| Comparative Example 2 | Metal layer/pressure-sensitive adhesive layer/resin layer/magnetic layer/resin layer/pressure-sensitive adhesive layer/metal layer | 35 | 50 | 9 | 3 | Present | Satisfying | 33% | 0.159 | 64 | 10 | 29 | 67 | 15 | Present | Absent |
| Comparative Example 3 | Metal layer/pressure-sensitive adhesive layer/resin layer/magnetic layer/resin layer/pressure-sensitive adhesive layer/metal layer | 35 | 50 | 255 | 3 | Present | Satisfying | 86% | 0.651 | 76 | 49 | 31 | 69 | 11 | Absent | Absent |
| Comparative Example 4 | Metal layer/magnetic layer/metal layer | 35 | 50 | - | - | Present | Satisfying | 19% | 0.135 | 46 | 6 | 29 | 65 | 15 | Present | Absent |
| Comparative Example 5 | Metal layer/adhesive layer/resin layer/double-sided tape/resin layer/adhesive layer/metal layer | - | 50 | 50 | 3 (adhesive layer) 5 (double-sided tape) | Absent | Satisfying | 84% | 0.211 | 95 | 20 | 19 | 42 | 15 | Absent | Absent |
| Comparative Example 6 | Metal layer/double-sided tape/magnetic layer/double-sided tape/metal layer | 35 | 50 | - | 5 | Present | Satisfying | 24% | 0.145 | 51 | 7 | 29 | 64 | 15 | Present | Absent |

From the results shown in Table 2, it can be confirmed that the electromagnetic wave shielding material of Example is capable of exhibiting a high shielding ability against a magnetic field wave in a low frequency region of about 100 kHz to 1 MHz and is excellent in forming workability.

Industrial Applicability

One aspect of the present invention is useful in the technical fields of various electronic components and various electronic apparatuses.

**Claims**

1. An electromagnetic wave shielding material,

   wherein at least one of outermost layers of the electromagnetic wave shielding material is a metal layer,
   a breaking elongation of the electromagnetic wave shielding material is 40% or more,
   a product of a thickness and a tensile strength of the electromagnetic wave shielding material is 40 N/mm or less, and
   the electromagnetic wave shielding material includes one or more magnetic layers sandwiched between two metal layers.

2. The electromagnetic wave shielding material according to claim 1,
   wherein both of the outermost layers of the electromagnetic wave shielding material are metal layers.

3. The electromagnetic wave shielding material according to claim 1,
   wherein one or both of the outermost layers of the electromagnetic wave shielding material is a metal layer that sandwiches a magnetic layer together with another metal layer.

4. The electromagnetic wave shielding material according to claim 1,
   wherein the electromagnetic wave shielding material further includes one or more layers containing a resin between the magnetic layer sandwiched between the two metal layers and one or both of the two metal layers.

5. The electromagnetic wave shielding material according to claim 4,
   wherein the resin is a polyester resin.

6. The electromagnetic wave shielding material according to claim 1,
   wherein the magnetic layer contains magnetic particles.

7. The electromagnetic wave shielding material according to claim 6,
   wherein the magnetic layer further contains a resin.

8. The electromagnetic wave shielding material according to claim 1,
   wherein a thickness of the magnetic layer is 5 $\mu$m or more and 100 $\mu$m or less.

9. The electromagnetic wave shielding material according to claim 1,
   wherein one or both of the two metal layers sandwiching the magnetic layer is a layer that contains, as a main component, a metal selected from the group consisting of Al, Mg, and Cu.

10. The electromagnetic wave shielding material according to claim 1,
    wherein the breaking elongation of the electromagnetic wave shielding material is 40% or more and 100% or less.

11. The electromagnetic wave shielding material according to claim 1,
    wherein the product of the thickness and the tensile strength of the electromagnetic wave shielding material is 5 N/mm or more and 40 N/mm or less.

12. The electromagnetic wave shielding material according to claim 1,

    wherein one or both of the outermost layers of the electromagnetic wave shielding material is a metal layer that sandwiches a magnetic layer together with another metal layer,
the electromagnetic wave shielding material further includes one or more layers containing a polyester resin between the magnetic layer sandwiched between the two metal layers and one or both of the two metal layers, the magnetic layer contains magnetic particles and a resin,
a thickness of the magnetic layer is 5 μm or more and 100 μm or less,
one or both of the two metal layers sandwiching the magnetic layer is a layer that contains, as a main component a metal selected from the group consisting of Al, Mg, and Cu,
the breaking elongation of the electromagnetic wave shielding material is 40% or more and 100% or less, and
the product of the thickness and the tensile strength of the electromagnetic wave shielding material is 5 N/mm or more and 40 N/mm or less.

13. An electronic component comprising:
the electromagnetic wave shielding material according to any one of claims 1 to 12.

14. An electronic apparatus comprising:
the electromagnetic wave shielding material according to any one of claims 1 to 12.

## INTERNATIONAL SEARCH REPORT

| International application No. |
|---|
| **PCT/JP2023/042096** |

### A.    CLASSIFICATION OF SUBJECT MATTER

*H05K 9/00*(2006.01)i; *B32B 7/022*(2019.01)i; *B32B 7/025*(2019.01)i; *B32B 15/08*(2006.01)i; *H01F 1/26*(2006.01)i; *H01F 1/37*(2006.01)i; *H01Q 17/00*(2006.01)i

FI:    H05K9/00 W; B32B7/022; B32B7/025; B32B15/08 D; H01F1/26; H01F1/37; H01Q17/00; H05K9/00 Q

According to International Patent Classification (IPC) or to both national classification and IPC

### B.    FIELDS SEARCHED

Minimum documentation searched (classification system followed by classification symbols)

H05K9/00; B32B7/022; B32B7/025; B32B15/08; H01F1/26; H01F1/37; H01Q17/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C.    DOCUMENTS CONSIDERED TO BE RELEVANT

| Category* | Citation of document, with indication, where appropriate, of the relevant passages | Relevant to claim No. |
|---|---|---|
| Y | JP 62-256498 A (KAWASAKI STEEL CORP) 09 November 1987 (1987-11-09)<br>page 1, lower right column, lines 3-19, page 2, upper left column, lines 9-14, lower left column, lines 2-8, lower right column, line 15 to page 3, upper right column, line 15, fig. 2 | 1-14 |
| Y | JP 2022-79311 A (TOYO ALUMINIUM KK) 26 May 2022 (2022-05-26)<br>paragraphs [0033], [0064], [0075]-[0077], [0088], fig. 5 | 1-14 |
| Y | JP 2019-21838 A (SHINETSU POLYMER CO) 07 February 2019 (2019-02-07)<br>paragraphs [0115], [0117] | 1-14 |

☐ Further documents are listed in the continuation of Box C.          ☑ See patent family annex.

| \* | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **09 January 2024** | **23 January 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2023/042096**

| Patent document cited in search report | | | Publication date (day/month/year) | Patent family member(s) | | | Publication date (day/month/year) |
|---|---|---|---|---|---|---|---|
| JP | 62-256498 | A | 09 November 1987 | (Family: none) | | | |
| JP | 2022-79311 | A | 26 May 2022 | (Family: none) | | | |
| JP | 2019-21838 | A | 07 February 2019 | CN | 208609256 | U | |

**EP 4 629 768 A1**

**Patent documents cited in the description**

- JP 2022091579 A
- JP 2018131640 A
- JP 2015187260 A

**Non-patent literature cited in the description**

- Electromagnetic wave shielding technology in a semiconductor package. *Toshiba Review*, 2012, vol. 67 (2), 8